# EUROPEAN PATENT SPECIFICATION

(11) **EP 0 603 438 B1**
(45) Date of publication and mention of the grant of the patent: **05.11.1997**
(21) Application number: 92311723.8
(22) Date of filing: 22.12.1992
(51) Int. Cl.: B25B 11/00

(54) **Suction tables for a numerical control router**
Unterdruckspanntafel für eine numerisch gesteuerte Fräsmaschine
Table de retenue à dépression pour une fraise à commande numérique

(43) Date of publication of application: 29.06.1994
(73) Proprietor: HEIAN CORPORATION, Hamamatsu-shi, Shizuoka-ken (JP)
(72) Inventor: Suzuki, Nobuyoshi, c/o Heian Corporation, Hamamatsu-shi, Shizuoka-ken (JP)
(74) Representative: Gordon, Michael Vincent

(56) References cited:
- WO-A-92/10336
- DE-A- 4 101 904
- US-A- 4 066 249
- US-A- 5 141 212

## Description

The present invention relates to suction tables for use with a sacrifice board and a process board during operation of a numerical control router.

In a known suction table for a numerical control router, the suction table is hollow, includes a reinforced and apertured wood plate cover, and is connected by a pipe to an electromagnetic valve and a vacuum pump. Generally, a sacrifice board is mounted on the suction table and a process board is fixed on the sacrifice board and is processed by a process head of the numerical control router. In the known suction table, the sacrifice board is the same size as the suction table and a plurality of suction holes are formed in the sacrifice board. Accordingly, because the air is sucked from the suction holes of the sacrifice board for the process board, while the process board is positioning on the suction table a suction loss becomes large and the process board cannot be precisely positioned on the sacrifice board.

When work on the process board fixed on the sacrifice board terminates, the suction of the process board is released by cutting off the electromagnetic valve and the process board is taken off on the sacrifice board. Because the compartment of the suction table is one, when the electromagnetic valve is cut off, the suction of the sacrifice board is released. Therefore, when the process board is carried out over the sacrifice board, the sacrifice board is shifted, a gap between the suction table and the sacrifice board is formed and debris falls into the gap.

It is also known from WO-A-92/10336, acknowledged in the pre-characterising portion of the present main claim, for a suction table to include a compartment divided into a peripheral portion and an inner portion, which are connected by piping through respective electromagnetic valves to a source of vacuum and which are covered by a plate having a plurality of suction holes extending therethrough, with the suction holes associated with the peripheral portion of the compartment being primarily intended for use in retaining a peripheral part of a sacrifice board, which has an inner part formed with a plurality of holes therethrough, and with the suction holes associated with the inner portion of the compartment being primarily intended for use in retaining a process board on the inner part of the sacrifice board.

According to the present invention, such a suction table is characterised in that the compartment is subdivided into two or more of said peripheral portions, each of which is associated with a respective plurality of the suction holes as well as a respective electromagnetic valve for simultaneously controlling the suction applied through said respective plurality of the suction holes to provide simple retention of different sacrifice boards, and in that the compartment is sub-divided into two or more of said inner portions, each of which is associated with a respective plurality of the suction holes as well as a respective electromagnetic valve for simultaneously controlling the suction applied through said respective plurality of the suction holes to provide simple retention of different process boards.

Preferably, a main electromagnetic valve is provided between the electromagnetic valves for said inner portions and said source of vacuum.

A suction table embodying the present invention, as well as two prior art suction tables, will now be described in greater detail, by way of example only, with reference to the accompanying drawings in which:-
Fig. 1 shows a cross-sectional view of a known suction table;
Fig. 2 shows a front view of a numerical control router;
Fig. 3 shows a plan view of the numerical control router in Fig. 2;
Fig. 4 shows a side view of the numerical control router in Fig. 2;
Fig. 5 shows a plan view of another known suction table whose cover plate is omitted for clarity;
Fig. 6 shows a side cross-sectional view of the full suction table in Fig. 5;
Fig. 7 shows a plan view of a suction table of the present invention whose cover plate is omitted for clarity; and
Fig. 8 shows a side cross-sectional view of the full suction table in Fig. 7.

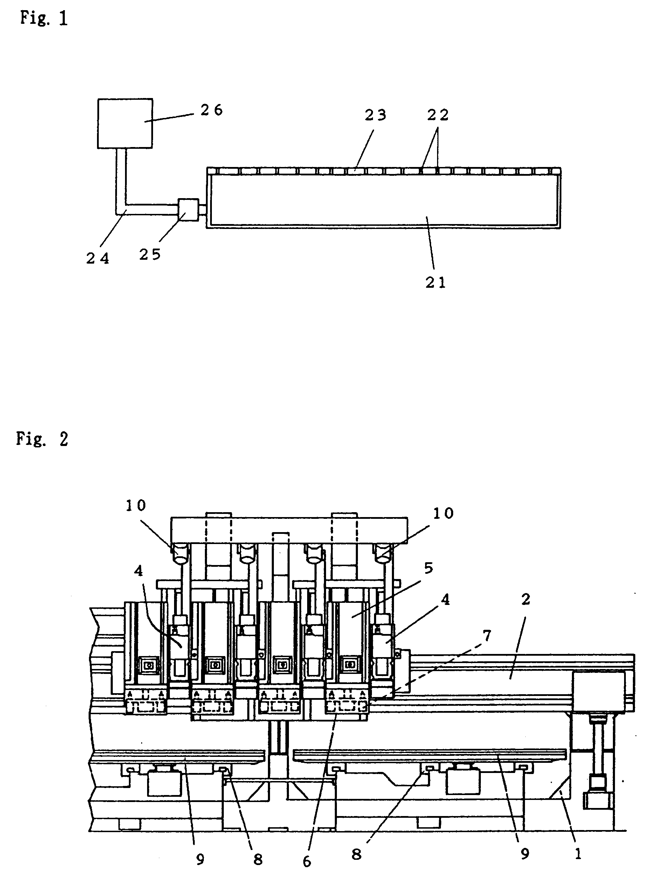

As shown in Fig. 1, in a known suction table of a numerical control router, the suction table has a single hollow compartment 21, on which a reinforced wood plate 23 having a plurality of holes 22 is mounted, an electromagnetic valve 25 is connected to a pipe 24 of the suction table and a vacuum pump 26 is connected to the pipe 24.

Generally, a sacrifice board is mounted on the suction table and a process board is fixed on the sacrifice board and is processed by a process head of a numerical control router. In the above suction table, the sacrifice board is the same size as the suction table and a plurality of suction holes are formed in the sacrifice board. Accordingly, because the air is sucked from the suction holes of the sacrifice board for the process board while the process board is positioning on the sacrifice board, a suction loss becomes large and the process board cannot be precisely positioned on the sacrifice board.

When the processing of the process board fixed on the sacrifice board terminates, the suction of the process board is released by cutting off the electromagnetic valve 25 and the process board is taken off on the sacrifice board. Because the compartment of the suction table is one, when the electromagnetic valve 25 is cut off, the suction of the sacrifice board is released. Therefore, when the process board is carried out on the sacrifice board, the sacrifice board is undesirably shifted, a gap between the suction table and the sacrifice board is formed and chips take into the gap.

Accordingly uniform manufactured articles cannot be made.

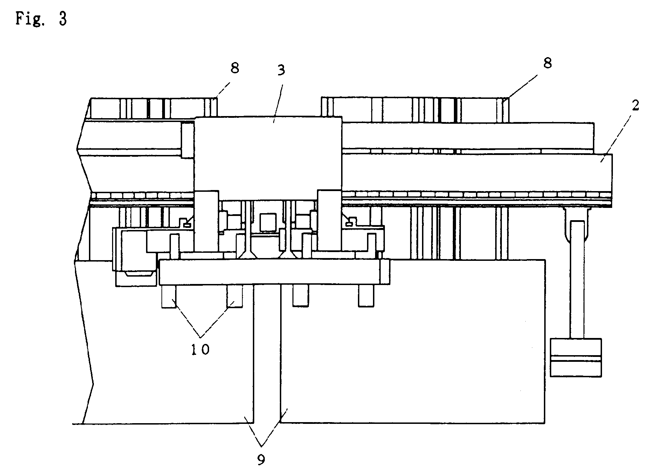

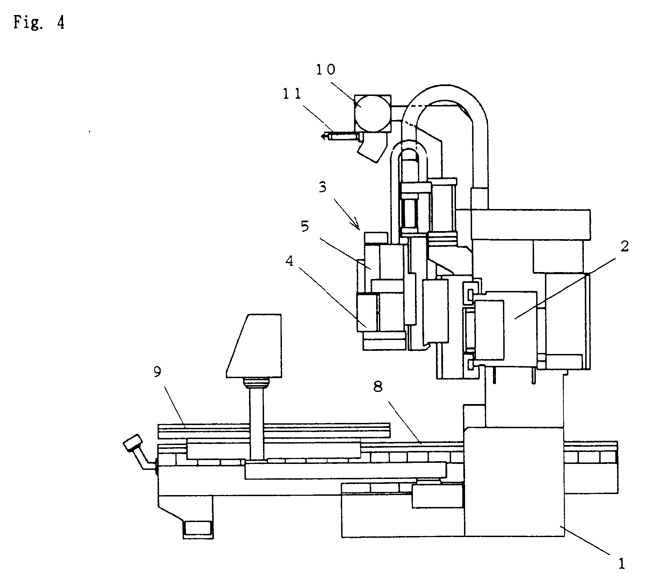

In Figs. 2, 3 and 4, a rail 2 is provided with a supporting bed 1, and a head structure 3 is mounted on the rail 2 to move left and right in Fig. 2. A plurality of heads 4 (4 heads in Fig. 2) are attached to the head structure 3, motors are provided with the heads 4 and a tool such as a drill or cutter is attached the rotary shaft of each motor.

A tool changer 5 and a tool magazine 6 having a plurality of tools 7 are attached to the side portion of each of the heads 4. Rails 8 are attached to the supporting bed 1 under the heads 4 and suction tables 9 are mounted on the rails 8 to move before and behind the heads 4. Ducts 10 are attached to upper portions of the heads 4, valves (not shown) opened or closed with cylinders 11 are attached to the ducts 10, and hoses (not shown) are connected to the ducts 10 to suck chips or dust on the suction table 9.

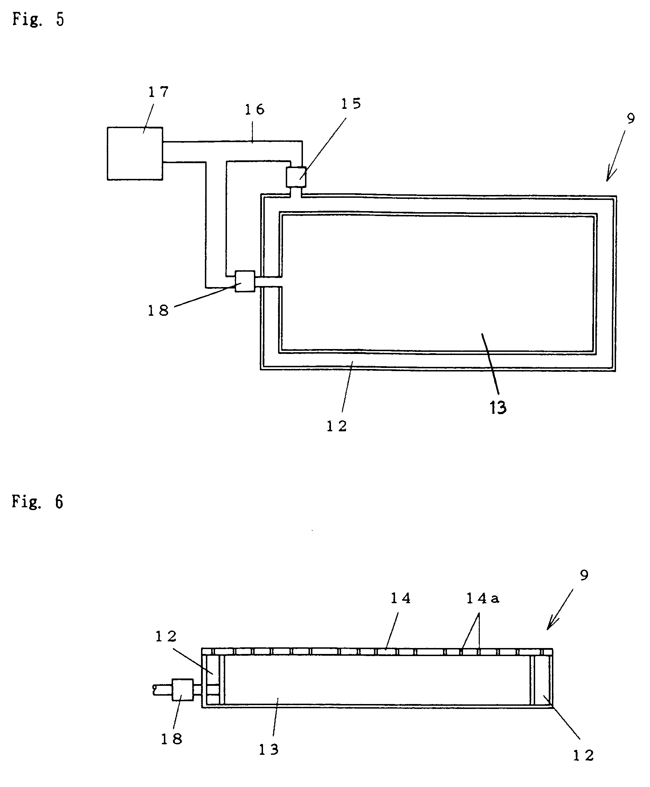

As shown in Figs. 5 and 6, the known suction table 9 forms a compartment 12 for the sacrifice board in the periphery of the suction table 9 and forms a compartment 13 in the inside of the suction table 9. A reinforced wood plate 14 having a plurality of suction holes 14a is stuck on the compartments 12 and 13. The compartment 12 for the sacrifice board is connected through electromagnetic valve 15 and pipe 16 to a vacuum device 17, and the compartment 13 for the process board is connected through electromagnetic valve 18 to the vacuum device 17.

In the above suction table, when the sacrifice board having suction holes only corresponding to the area of the process board is positioned, the electromagnetic valve 15 is opened and the sacrifice board is sucked on the reinforced wood plate 14 of the table 9 with the suction of the suction holes in the periphery of the reinforced wood plate 14.

The electromagnetic valve 18 is opened when the process board is positioned on the sacrifice board.

Because the compartment of the suction table 9 is divided into the compartment 12 for sucking the sacrifice board and the compartment 13 for sucking the process board, air cannot leak from the suction holes for sucking the process board while the sacrifice board is positioned on the suction table 9 and the suction loss is improved.

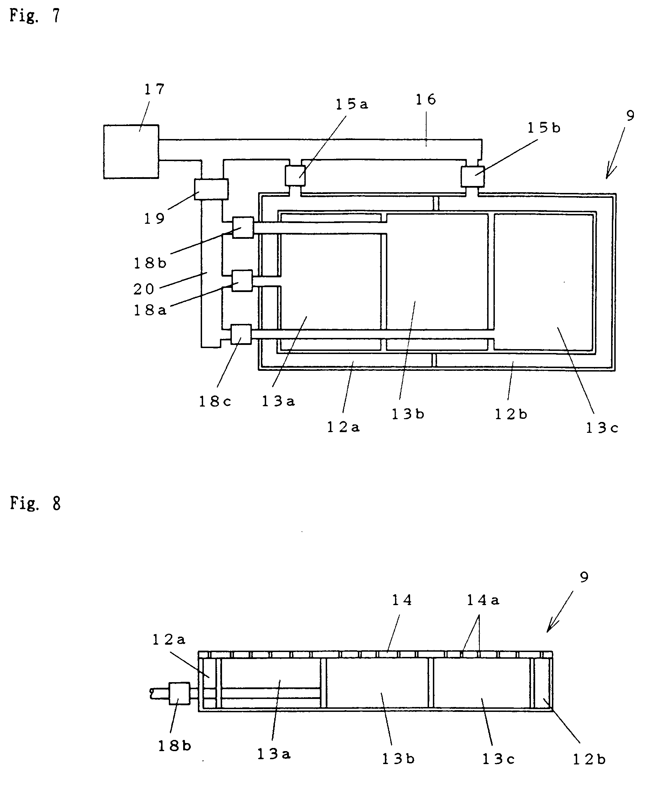

As shown in Figs. 7 and 8, in the suction table of the present invention, the suction table 9 forms compartments 12a and 12b for the sacrifice board in the periphery of the suction table 9 and forms compartments 13a, 13b and 13c in the inside of the suction table 9. A reinforced wood plate 14 having a plurality of suction holes 14a is stuck on the compartments 12a, 12b, 13a, 13b and 13c. The compartments 12a, 12b for the sacrifice board are connected through electromagnetic valves 15a and 15b and pipe 16 to a vacuum device 17, and the compartments 13a, 13b and 13c are connected through electromagnetic valves 18a, 18b and 18c, a pipe 20 and a main electromagnetic valve 19 to the vacuum device 17.

In the above suction table, when the sacrifice board having suction holes corresponding to the size of the process board is positioned, each or both of the electromagnetic valves 15a and 15b are opened and the sacrifice board is sucked on the reinforced wood plate 14 of the table 9 with the suction of the suction holes in the periphery of the reinforced wood plate 14.

When the process board is smaller than a half of the suction table 9, one of the electromagnetic valves 18a, 18b and 18c is opened, and the process board is sucked on the associated compartment 13a, 13b and 13c, each being smaller than the half portion of the sacrifice board.

Also, when the process board is the same size as the sacrifice board, the electromagnetic valves 18a, 18b and 18c are all opened and the process board is positioned on the sacrifice board.

In this embodiment of the present invention, because the compartment of the suction table 9 is divided into the compartments 12a and 12b for sucking the sacrifice board and the compartments 13a, 13b and 13a for sucking the process board, air cannot leak from the suction holes for sucking the process board while the sacrifice board is positioned on the suction table 9 and the suction loss is improved. Also, after the sacrifice board is positioned on the suction table 9, the process board is precisely positioned on the sacrifice board.

The main electromagnetic valve 19 can hold the pressure of the predetermined value in the compartments for the sacrifice board 12a and 12b by closing the electromagnetic valves 18a, 18b and 18c after the electromagnetic valve 19 is closed. Also, when the process board is the same size as the sacrifice board, the positioning or removing of the process board is performed by the electromagnetic valve 19 without using the electromagnetic valves 18a, 18b and 18c.

## Claims

1. A suction table (9) comprising a compartment divided into a peripheral portion and an inner portion, which are connected by piping through respective electromagnetic valves to a source of vacuum (17) and which are covered by a plate (14) having a plurality of suction holes (14a) extending therethrough, with the suction holes (14a) associated with the peripheral portion of the compartment being primarily intended for use in retaining a peripheral part of a sacrifice board, which has an inner part formed with a plurality of holes therethrough, and with the suction holes (14a) associated with the inner portion of the compartment being primarily intended for use in retaining a process board on the inner part of the sacrifice board,
characterised in that the compartment is sub-divided into two or more of said peripheral portions (12a, 12b), each of which is associated with a respective plurality of the suction holes (14a) as well as a respective electromagnetic valve (15a, 15b) for simultaneously controlling the suction applied through said respective plurality of the suction holes (14a) to provide simple retention of different sacrifice boards, and in that the compartment is sub-divided into two or more of said inner portions (13a, 13b, 13c), each of which is associated with a respective plurality of the suction holes (14a) as well as a respective electromagnetic valve (18a, 18b, 18c) for simultaneously controlling the suction applied through said respective plurality of the suction holes (14a) to provide simple retention of different process boards.

2. A suction table according to claim 1, characterised in that a main electromagnetic valve (19) is provided between the electromagnetic valves (18a, 18b, 18c) for said inner portions and said source of vacuum (17).

## Patentansprüche

1. Unterdrucktafel (9) mit einer Kammer, welche in einen peripheren und einen inneren Teil unterteilt ist, die durch ein Rohrnetz über entsprechende, elektromagnetische Ventile mit einer Vakuumquelle (17) verbunden und mit einer Platte (14) versehen sind, welche mehrere, sich durch diese erstreckende Sauglöcher (14a) aufweist, wobei die dem peripheren Teil der Kammer zugeordneten Sauglöcher (14a) in erster Linie dazu dienen sollen, einen peripheren Teil einer Schutzplatte, welche einen mit mehreren Löchern versehenen, inneren Teil aufweist, zu halten, und wobei die dem inneren Teil der Kammer zugeordneten Sauglöcher (14a) in erster Linie dazu dienen sollen, eine Arbeitsplatte auf dem Innenteil der Schutzplatte zu halten,
dadurch gekennzeichnet, daß die Kammer in zwei oder mehrere periphere Teile (12a, 12b) unterteilt ist, von denen jeder einer jeweiligen großen Anzahl Sauglöcher (14a) sowie einem jeweiligen elektromagnetischen Ventil (15a, 15b) zugeordnet ist, um die durch die jeweilige große Anzahl Sauglöcher (14a) zugeführte Ansaugung gleichzeitig zu steuern, um die verschiedenen Schutzplatten zu halten, und daß die Kammer in zwei oder mehrere innere Abschnitte (13a, 13b, 13c) unterteilt ist, von denen jeder einer jeweiligen großen Anzahl Sauglöcher (14a) sowie einem jeweiligen elektromagnetischen Ventil (18a, 18b, 18c) zugeordnet ist, um die durch die jeweilige große Anzahl Sauglöcher (14a) zugeführte Ansaugung gleichzeitig zu steuern, um die verschiedenen Arbeitsplatten zu halten.

2. Unterdruckspanntafel nach Anspruch 1, dadurch gekennzeichnet, daß ein elektromagnetisches Hauptventil (19) zwischen den elektromagnetischen Ventilen (18a, 18b, 18c) für die inneren Abschnitte und die Vakuumquelle (17) vorgesehen ist.

## Revendications

1. Table à dépression (9) comprenant un compartiment divisé en une portion périphérique et une portion intérieure, qui sont reliées à une source de vide (17) par une canalisation et à travers des soupapes électromagnétiques respectives et qui sont recouvertes par une plaque (14) présentant une pluralité de trous d'aspiration (14a) qui la traversent, les trous d'aspiration (14a) associés à la portion périphérique du compartiment étant principalement destinés à servir à retenir une partie périphérique d'une planche martyr, laquelle possède une partie intérieure munie d'une pluralité de trous qui la traversent, et les trous d'aspiration (14a) associés à la portion intérieure du compartiment étant principalement destinés à servir à retenir une planche à travailler sur la partie intérieure de la planche martyr.
caractérisée en ce que le compartiment est subdivisé en deux ou plus de deux desdites portions périphériques (12a, 12b), dont chacune est associée à une pluralité respective de trous d'aspiration (14a), ainsi qu'à une soupape électromagnétique respective (15a, 15b) servant à commander simultanément l'aspiration appliquée à travers ladite pluralité respective de trous d'aspiration (14a) pour assurer une retenue simple de différentes planches à travailler, et en ce que le compartiment est subdivisé en deux ou plus de deux desdites portions intérieures (13a, 13b, 13c), dont chacune est associée à une pluralité respective de trous d'aspiration (14a) , ainsi qu'à une soupape électromagnétique respective (18a, 18b, 18c) servant à commander simultanément l'aspiration appliquée à travers ladite pluralité respective de trous d'aspiration (14a) pour assurer une retenue simple de différentes planches à travailler.

2. Table à dépression selon la revendication 1, caractérisée en ce qu'une soupape électromagnétique principale (19) est prévue entre les soupapes électromagnétiques (18a, 18b, 18c) prévues pour lesdites portions intérieures et ladite source de vide (17).
